# EUROPÄISCHE PATENTSCHRIFT

(11) **EP 0 226 892 B1**
(45) Veröffentlichungstag und Bekanntmachung des Hinweises auf die Patenterteilung: **08.09.1993**
(21) Anmeldenummer: 86116739.3
(22) Anmeldetag: 02.12.1986
(51) Int. Cl.: H01L 21/82, H01L 21/28, H01L 27/06

(54) **Verfahren zum Herstellen von bipolaren Transistoren und komplementären MOS-Transistoren auf einem gemeinsamen Siliziumsubstrat**
Process for manufacturing of bipolar and complementary MOS-transistors on a common silicon substrate
Procédé pour la fabrication de transistors bipolaires et MOS-complémentaires sur un substrat commun en silicium

(30) Priorität: 17.12.1985 DE 3544599
(43) Veröffentlichungstag der Anmeldung: 01.07.1987
(73) Patentinhaber: SIEMENS AKTIENGESELLSCHAFT, 80333 München (DE)
(72) Erfinder: Schaber, Hans-Christian, Dr., D-8032 Gräfelfing (DE)

(56) Entgegenhaltungen:
- EP-A- 0 054 259
- EP-A- 0 083 785
- EP-A- 0 110 313
- IBM TECHNICAL DISCLOSURE BULLETIN Band 24, Nr. 1B, Juni 81, Seiten 466-470, New York, USA ; J. A. DORLER et al.: "Complementary bipolar-FET integrated circuit"
- idem
- ELEKTROTECHNIK UND MASCHINENBAU Band 103, Nr. 1, Januar 1985, Seiten34-37, Wien, Oesterreich; P. SIEBER: "Telefunken electronic auf dem Weg zur Submikron-Technologie"
- PATENT ABSTRACTS OF JAPAN Band 7, Nr. 280 (E-216)(1425), 14. Dezember 1983; & JP-A-58 158942

## Beschreibung

Die Erfindung betrifft ein Verfahren zum gleichzeitigen Herstellen von bipolaren Transistoren und komplementären MOS-Transistoren auf einem gemeinsamen Substrat, bei dem durch maskierte Implantation n- und p-dotierte Bereiche erzeugt werden, bei dem Basis- und Emitterzone des Biplartransistors durch Ausdiffusion aus leitenden Schichtstrukturen hergestellt werden und bei dem in die n-dotierten Bereiche npn-Bipolar-Transistoren gelegt werden, wobei die n-dotierten Bereiche den Kollektor des Bipolartransistors bilden.

Die Erfindung betrifft insbesondere ein Verfahren der obengenannten Art, bei dem die n-Bereiche, in die die Bipolar-Transistoren gelegt werden, den Kollektor des Transistors bilden und vergrabene n⁺-dotierte Zonen bedecken, die im Bipolar-Transistorbereich durch tiefreichende Kollektoranschlüsse angeschlossen werden.

Ein solches Verfahren für eine 1,0 µm Wannen-CMOS/Bipolar-Technik für höchstintegrierte Schaltungen ist beispielsweise aus einem Aufsatz von Miyamoto et. al. aus dem IEDM 1983, Technical Digest, auf den Seiten 63 bis 66, zu entnehmen. Zur Verringerung des Kollektorwiderstandes wird ein vergrabener Kollektor verwendet, der durch einen tiefen Kollektorkontakt angeschlossen wird.

Eine 2,0 µm CMOS-Bipolartechnologie ist auch aus einem Aufsatz von A. R. Alvarez et. al. aus dem IEDM 1984, Technical Digest, auf den Seiten 761 bis 764, zu entnehmen, bei der durch Verzicht auf Selbstjustierung und Polysiliziumbasisanschlüsse hohe Basisbahnwiderstände in Kauf genommen werden, was auf Kosten der Schaltgeschwindigkeit der Bipolar-Transistoren geht.

Die Herstellung eines Bipolar-Transistors mit einem vergrabenen Kollektor und selbstjustierten Basis/Emitter-Bereichen, bei dem die Emitter- und Basiszonen durch Ausdiffusion aus dotierten Polysiliziumstrukturen gebildet werden, ist aus einem Aufsatz von H. Murrmann "Modern Bipolar Technology for High Performance ICs" aus den Siemens Forschungs- und Entwicklungs-Berichten, Band 5 (1976), Nr. 6, Seiten 353 bis 359, und aus einem Aufsatz von A. Wieder "Self-aligned Bipolar Technology - New Chances for Very-High Speed Digital Integrated Circuits" in den Siemens Forschungs- und Entwicklungsberichten, Band 13 (1984), auf den Seiten 264 bis 252, zu entnehmen. Solche Transistoren werden in LSI-Schaltungen für hohe Schaltgeschwindigkeiten verwendet.

Aufgabe der Erfindung ist es, ein Verfahren zur Herstellung von hochintegrierten Schaltungen mit CMOS- und Bipolar-Transistoren anzugeben, welches größtmögliche Systemgeschwindigkeiten ermöglicht. Dabei sollen selbstjustierte, geschwindigkeitsoptimierte Bipolar-Transistoren gleichzeitig und kompatibel mit einem Hochgeschwindigkeits-CMOS-Prozeß hergestellt werden. Durch das Verfahren soll insbesondere eine vollständig prozeßtechnische Entkopplung der beiden Transistortypen, bei der die Emitter der Bipolar-Transistoren unabhängig von der Erzeugung der Gate-Elektroden und der kritischen Bereiche der Source/Drain-Zonen (lightly doped drain-Bereiche) der n-Kanal-MOS-Transistoren dotiert werden, ohne großen Mehraufwand durch komplizierte Maskierungsschritte erreicht werden.

Die erfindungsgemäße Aufgabe wird durch ein Verfahren nach Anspruch 1 gelöst.

In einer Version des erfindungsgemäßen Verfahrens kann die Herstellung des aktiven Basisbereiches durch Bor-Ionenimplantation nach Verfahrensschritt 1) bei entsprechender Wahl der Dicke der als Schutzschicht dienenden ersten Isolatorschicht ohne Photolackmaske erfolgen, so daß ganzflächig in einem Schritt die Basisimplantation mit der Kanalimplantation für die MOS-Transistoren durchgeführt wird.

Weitere Ausgestaltungen der Erfindung ergeben sich aus den Unteransprüchen.

Durch die erfindungsgemäße Verfahrensfolge, welche gegenüber den herkömmlichen CMOS-Prozessen in Doppel-Poly-Silizium-Gate-Technologie (siehe Aufsatz von E. P. Jacobs et. al. IEDM 84, Technical Digest (1984) auf den Seiten 642 bis 646) zur gleichzeitigen Herstellung von selbstjustierten Bipolar-Transistoren in Doppel-Poly-Silizium Technologie nur wenige einfache zusätzliche Verfahrensschritte erfordert (Verfahrensmerkmale h), l), p), q)), ist die Möglichkeit gegeben, den Emitter des Bipolar-Transistors zur Erzielung eines flachen pn-Überganges mit Arsen und die Source/Drain-Zonen der MOS-Transistoren zur Verbesserung der Spannungsfestigkeit mit Phosphor zu dotieren.

Durch die Verwendung von Polysilizium oder Polizid als Emitteranschluß wird ein höherer Emitterwirkungsgrad erreicht.

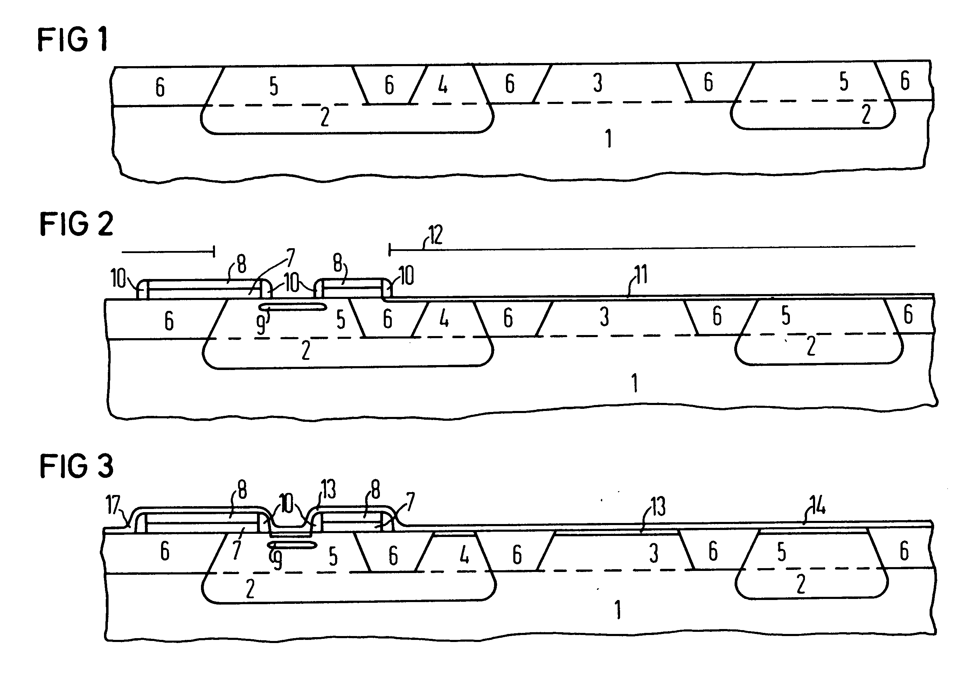

Im folgenden wird anhand der Figuren 1 bis 5 und eines Ausführungsbeispiels der Prozeßablauf noch näher beschrieben. Dabei sind in den Figuren im Schnittbild nur die erfindungswesentlichen Verfahrensschritte dargestellt; für gleiche Teile sind gleiche Bezugszeichen vorgesehen.

Figur 1: Die hier abgebildete Anordnung wird durch folgende Schritte erzeugt:
a) Bildung des vergrabenen Kollektorbereiches 2 in einem p-dotierten Siliziumsubstrat 1 durch maskierte Ionenimplantation von Antimon oder Arsen mit einer Dosis und Energie von 3 x 10¹⁵ cm⁻² und 80 keV,
b) Abscheidung einer p-dotierten Epitaxieschicht,
c) Aufbringen einer aus Siliziumoxid und Siliziumnitrid bestehenden Doppelschicht und entsprechende Strukturierung der Siliziumnitridschicht für den nachfolgenden LOCOS-Schritt,
d) Herstellung des für die Trennung der aktiven Transistorbereiche T_{A}, T_{B}, T_{C} (siehe Figur 5) im Substrat 1 erforderlichen Feldoxids 6 durch lokale Oxidation unter Verwendung der bei c) erzeugten Siliziumnitridstruktur als Oxidationsmaske,
e) Erzeugung der n-Bereiche (Wannen) 5 durch eine maskierte Phosphor-Ionenimplantation mit einer Dosis und Energie von 2 x 10¹² cm⁻² und 180 keV und der Bereiche für den tiefreichenden Kollektoranschluß durch eine Tiefimplantation mit Phosphorionen bei einer Dosis und Energie von 3 x 10¹⁵ cm⁻² und 80 keV und Eindiffusion, wobei auch der Kollektoranschluß 4 bis zum Kollektorbereich 2 eingetrieben wird, und
f) Entfernen der Nitrid/Oxid-Maske.

Im Bedarfsfall können unter den Feldoxidbereichen 6 auch sogenannte "channel-stopper"-Bereiche (21) durch Bor-Ionenimplantation erzeugt werden (Näheres siehe Figur 5).

Fiqur 2: Auf der die n- und p-dotierten Bereiche 3, 4, 5 und die Feldoxidbereiche 6 enthaltenden Oberfläche des Substrates 1 wird ganzflächig eine als Schutzschicht bei der späteren Basisimplantation wirkende SiO₂-Schicht 11 (erste Isolatorschicht, im Bereich von 20 bis 100 nm) aufgebracht und mittels Photolacktechnik so strukturiert, daß zumindest die Basis- und Emitterbereiche des Bipolar-Transistors T_{A} wieder freigelegt werden. Die über der Anordnung eingezeichnete Linie 12 markiert den mit dem Schutzoxid belegten Oberflächenbereich. Nach Ablösen der Photolackmaske wird die aus einer p⁺-leitenden Schicht 7 und einer zweiten Isolationsschicht 8 bestehende Struktur aufgebracht. Die p⁺-leitende Schicht 7 besteht aus Polysilizium oder Metallsilizid und dient als Bordiffusionsquelle bei der Erzeugung der Basisanschlußzone (22) des Bipolar-Transistors T_{A}. Die Isolationsschicht 8 besteht aus SiO₂. Die Strukturierung der Doppelschicht (7, 8) erfolgt mittels Trockenätzverfahren, zum Beispiel die Ätzung der SiO₂-Schicht 8 durch reaktives Ionenätzen in einem Trifluoirmethan/Sauerstoff-Gasgemisch und die Ätzung der Polysiliziumschicht 7 anschließend in einem Tetrachlorkohlenstoff (CCl₄)/Helium-Plasma. Bei diesen Ätzprozessen werden senkrechte Flanken erhalten. Das Substrat sollte dabei möglichst wenig (weniger als 50 nm) angeätzt werden. Nach dieser Strukturierung wird der aktive Basisbereich 9 durch Implantation von Bor-Ionen erzeugt. Mit dieser Basisimplantation für die Bipolar-Transistoren T_{A} kann auch bei entsprechender Wahl der Dicke des Schutzoxids 11 die Kanalimplantation für die MOS-Transistoren T_{B}, T_{C} ganzflächig durchgeführt werden. Zur unabhängigen Optimierung der Bipolar-Transistoren T_{A} kann aber auch die Basisimplantation (9) durch eine Lackmaske auf den Bereich der Bipolar-Transistoren (ohne Kollektoranschlußbereich) beschränkt werden (wie in der Figur 2 dargestellt ist). Schließlich wird eine gut-kantenbedeckende SiO₂-Schicht (dritte Isolatorschicht, 1. spacer oxid) ganzflächig aufgebracht und durch eine anisotrope Ätzung, zum Beispiel durch reaktives Ionenätzen mit einem CHF₃/O₂-Gasgemisch so strukturiert, daß nur an den Flanken der p-leitenden Schichtstruktur 7 (8) laterale Isolationsstege 10 stehenbleiben. Bei diesem Ätzprozeß wird auch die Substratoberfläche (1) mit den aktiven Bereichen der MOS-Transistoren T_{B}, T_{C} und der Kollektorkontaktbereich K der Bipolar-Transistoren T_{A} freigeätzt.

Figur 3: Es erfolgt nun das Aufbringen einer vierten Isolatorschicht (5...50 nm), die in den MOS-Transistorbereichen T_{B}, T_{C} als Gate-Dielektrikum (Gateoxid) 13 dient. Darauf wird ganzflächig eine erste Polysiliziumschicht 14 in einer Schichtdicke kleiner 150 nm abgeschieden und durch Phosphordiffusion n-leitend gemacht.

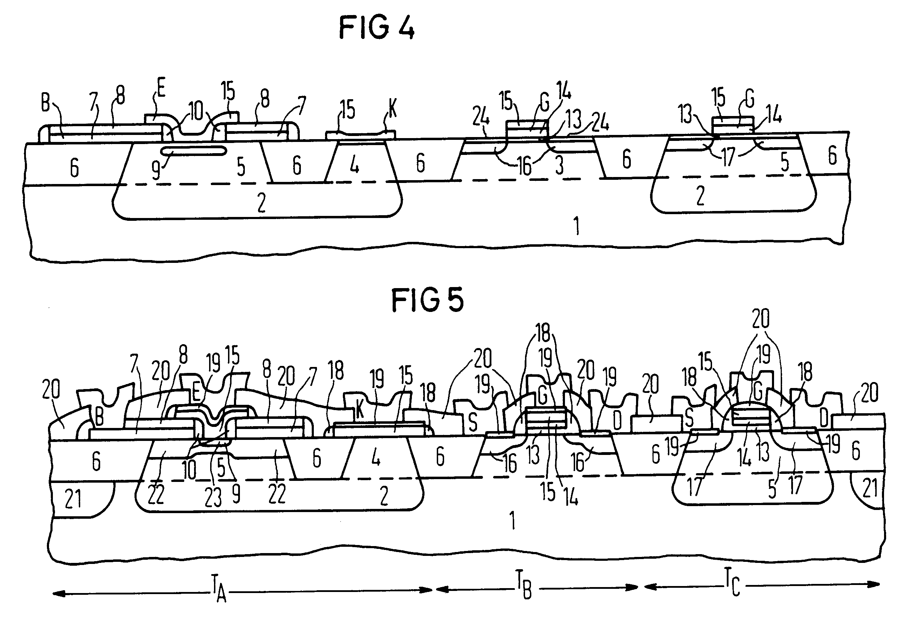

Figur 4: Die mit Phosphor dotierte Polysiliziumschicht 14 und die darunterliegende vierte Isolationsschicht 13 wird mittels Photolithographie so strukturiert, daß in den Emitter- und Kollektor-Bereichen der Bipolar-Transistoren T_{A} die Substratoberfläche wieder freigelegt wird. Nach Entfernen der Photolackmaske wird eine zweite Polysiliziumschicht 15 in einer Schichtdicke im Bereich von 100 bis 300 nm aufgebracht und mit den darunterliegenden Schichtstrukturen 13 und 14 mittels Photolacktechnik so strukturiert, daß die Gate-Elektroden G der MOS-Transistoren T_{B}, T_{C} und der Emitter E - und der Kollektorkontaktbereich K der Bipolar-Transistoren T_{A} entsteht. Anschließend erfolgt die Phosphor-Implantation zur Erzeugung der Source/Drain-Anschlußgebiete 24 (LDD = lightly doped drain für "weichen" pn-Übergang am Drain) der n-Kanal-MOS-Transistoren T_{B}. Die zur Strukturierung der ersten und zweiten Polysiliziumschicht (14, 15) verwendete Lackmaske wird abgelöst und nach erfolgter Photolithographie die zur Erzeugung der Source/Drain-Zonen 16 der n-Kanal-MOS-Transistoren T_{B} und zur Dotierung der Emitter- und Kollektorkontaktbereiche (E, K) der Bipolar-Transistoren T_{A} erforderliche Arsen-Ionenimplantation in bekannter Weise durchgeführt. Anschließend erfolgt in gleicher Weise nach entsprechender Photolackmaskierung die Erzeugung der Source/Drain-Zonen 17 der p-Kanal-MOS-Transistoren T_{C}.

Figur 5: Bei der Eindiffusion der die Source/Drain-Zonen 16, 17 erzeugenden Ionen bei zum Beispiel 950°C wird gleichzeitig der Dotierstoff aus den die Emitter- und Basisanschlußgebiete bildenden Strukturen 7, 15 ausgetrieben und die Basis-und Emitterzone 22, 23 erzeugt.

Zur Vermeidung von Gate/ Drain-Überlapp bei den MOS-Transistoren T_{B}, T_{C} kann vor den Source/Drain-Implantationen (16, 17) an den Flanken der Polysiliziumschichtstrukturen 14, 15 ein Isolationsoxid 18 (2. spacer oxid) erzeugt werden. Dabei wird auch die Flankenisolation 10 der Schichtstruktur 7 (8) verstärkt. Alle aktiven Gebiete der Transistoren T_{A}, T_{B}, T_{C} mit Ausnahme des durch die Struktur 7 gebildeten Basisanschlusses können durch selektive Abscheidung eines Metalles oder Metallsilizides kontaktiert werden. Die Silizidschichtstruktur ist in Figur 5 mit dem Bezugszeichen 19 bezeichnet. Die Kontaktierung kann aber auch durch selbstjustierte Bildung eines Silizids (self aligned silicide) auf den freiliegenden Siliziumoberflächen erfolgen.

Die Erzeugung einer als Isolationsoxid dienenden Zwischenschicht 20, das Öffnen der Kontaktlöcher zu den p⁺- bzw. n⁺-leitenden Schichten 19, die oberhalb der Source/Drain-Zonen 16, 17 angeordnet sind, und zu den aus den Strukturen 7, 15, 19 bestehenden Anschlüssen des Basis-, Emitter- und Kollektorbereiches der Bipolar-Transistoren T_{A} sowie der Gate-Elektroden G erfolgt in bekannter Weise; desgleichen auch die Durchführung der Metallisierung.

In der Figur 5, die die fertige Transistoranordnung zeigt, sind außerdem die bereits bei der Beschreibung der Figur 1 erwähnten, unter den Feldoxidbereichen 6 erzeugten "channel stopper"-Bereiche 21 eingezeichnet. Sie haben die Funktion, für eine sichere Isolation zwischen benachbaren Kollektorgebieten zu sorgen, indem die Einsatzspannung des parasitären Dickoxidtransistors auf Werte oberhalb der maximalen Betriebsspannung erhöht wird.

## Patentansprüche

1. Verfahren zum gleichzeitigen Herstellen von bipolaren (T_{A}) und komplementären MOS (CMOS)-Transistoren (T_{B}, T_{C}) auf einem gemeinsamen Siliziumsubstrat (1), bei dem auf dem p-dotierten Siliziumsubstrat (1) n-dotierte Bereiche (5) erzeugt werden, welche zum einen Teil für die Aufnahme von p-Kanal-Transistoren (T_{C}) dienen und welche sich zum anderen Teil im Bereich isolierter npn Bipolartransistoren (T_{A}) befinden, wobei die letztgenannten n-dotierten Bereiche (5) den Kollektor der Bipolartransistoren (T_{A}) bilden, und bei dem alle n-dotierten Bereiche (5) vergrabene n⁺-dotierte Zonen (2) bedecken, die im Bereich der Bipolartransistoren (T_{A}) durch tiefreichende Kollektoranschlüsse (4) angeschlossen werden, **gekennzeichnet durch** den Ablauf folgender Verfahrensschritte:
a) Herstellen der vergrabenen n⁺-dotierten Zonen (2) im p-dotierten Substrat (1) durch Implantation von n-dotierenden Ionen nach vorheriger Maskierung der übrigen Bereiche,
b) ganzflächiges Aufbringen einer p- oder n-dotierten Epitaxieschicht,
c) Aufbringen einer aus Siliziumoxid und Siliziumnitrid bestehenden Doppelschicht und entsprechende Strukturierung der Siliziumnitridschicht für die nachfolgende lokale Oxidation (LOCOS),
d) Herstellung des für die Trennung der aktiven Bereiche der Transistoren (T_{A}, T_{B}, T_{C}) im Substrat (1) erforderlichen Feldoxids (6) durch lokale Oxidation und unter Verwendung der Siliziumnitrid-Struktur als Oxidationsmaske,
e) Erzeugen der n-dotierten Bereiche (5) und von p-Bereichen (3) in dem um die Epitaxieschicht erweiterten Substrat (1) durch Implantation von n- bzw. p-dotierenden Ionen sowie der Bereiche für den tiefreichenden Kollektoranschluß (4) durch eine Tiefimplantation mit n-dotierenden Ionen und Eindiffusion,
f) Entfernen der Nitrid/Oxidmaske,
g) ganzflächiges Erzeugen einer ersten Isolatorschicht (11) in einer Schichtdicke, die als Ätzstop für die spätere Strukturierung einer Basiskontaktschichtstruktur ausreicht,
h) Durchführung einer Photolacktechnik und Freiätzen der zumindest aus Basis- und Emitterbereich bestehenden Bipolar-Transistorbereiche (T_{A}) von der ersten Isolatorschicht (11),
i) ganzflächige Abscheidung einer p⁺-leitenden Schicht (7) aus Polysilizium oder Metallsilizid nach Entfernen der Photolackmaske,
j) ganzflächige Abscheidung einer zweiten Isolatorschicht (8),
k) Durchführung einer Photolacktechnik und Strukturierung der p⁺-leitenden Schicht (7) und der zweiten Isolatorschicht (8) mit senkrechten Flanken bis zur Freilegung des Substrats (1) mittels eines Trockenätzverfahrens zur Definition des Basisbereiches der Bipolartransistoren (T_{A}),
l) Herstellung des aktiven Basisbereiches (9) durch Bor-Ionenimplantation nach erfolgter Photolackmaskierung der übrigen Bereiche,
m) ganzflächige Abscheidung einer die Strukturen der p⁺-leitenden Schicht (7) und der zweiten Isolatorschicht (8) gut kantenbedeckenden dritten Isolatorschicht (10) nach Entfernung der Photolackmaske,
n) Durchführung eines anisotropen Ätzprozesses zur Erzeugung von lateralen Isolationsstegen (10) aus der dritten Isolatorschicht an den Flanken der p⁺-leitenden Schichtstrukturen (7) und zum Freiätzen der Substratoberflächen in den aktiven Bereichen der MOS-Transistoren (T_{B}, T_{C}) und im Kollektorkontaktbereich (K) der Bipolar-Transistoren (T_{A}),
o) Aufbringen der Gateisolatorschicht (13) der MOS-Transistoren (T_{B}, T_{C}),
p) ganzflächige Abscheidung einer ersten Polysiliziumschicht (14) mit einer Schichtdicke kleiner 150 nm und Dotierung dieser Schicht (14) mit Phosphor,
q) Durchführung einer Photolacktechnik und Struktrierung der ersten Polysiliziumschicht (14) und der darunterliegenden Gateisolatorschicht (13) so, daß in den Emitter- und Kollektorkontaktbereichen (E, K) die Siliziumsubstratoberfläche (1) freigelegt wird, und Ablösen der Photolackmaske,
r) ganzflächiges Abscheiden einer zweiten Polysiliziumschicht (15) mit einer Schichtdicke im Bereich von 100 bis 300 nm,
s) Durchführung einer Photolacktechnik und Strukturierung der ersten und zweiten Polysiliziumschicht (14, 15) zur Erzeugung der Gate-Elektroden (G) der MOS-Transistoren (T_{B}, T_{C}) und des Kollektor- und Emitterkontaktbereiches (K, E) der Bipolar-Transistoren (T_{A}),
t) Durchführung einer Phosphorionenimplantation zur Erzeugung der Source/Drain-Anschlußgebiete der n-Kanal-MOS-Transistoren (T_{B}) und Ablösen der zur Strukturierung nach Verfahrensschritt s) verwendeten Lackmaske,
u) Durchführung einer mit Photolack maskierten Arsen-Ionenimplantation zur Erzeugung der Source/Drain-Zonen (16) der n-Kanal-Transistoren (T_{B}) und zur Dotierung der Emitter- und Kollektorkontaktbereiche (E, K) der Bipolar-Transistoren (T_{A}),
v) Durchführung einer mit Photolack maskierten Bor-Ionenimplantation zur Erzeugung der Source/Drain-Zonen (17) der p-Kanal-Transistoren (T_{C}),
w) ganzflächiges Erzeugen einer als Isolationsoxid dienenden Zwischenschicht (20) auf der Oberfläche der Struktur,
x) Durchführung einer Hochtemperaturbehandlung im Bereich von 900°C zur Eindiffusion von Arsen in die Source/Drain-Zonen (16) und in die Emitter- und Kollektorbereiche sowie von Bor in die Source/Drain-Zonen (17) und in die Basiskontaktbereiche (B).
y) Öffnen der Kontaktlöcher zu den p⁺-bzw. n⁺-leitenden Anschlüssen der aktiven Transistorbereiche und Durchführung der Metallisierung.

2. Verfahren nach Anspruch 1, **dadurch gekennzeichnet,** daß der Verfahrensschritt 1) ohne Photolackmaskierung durchgeführt wird.

3. Verfahren nach Anspruch 1 oder 2, **dadurch gekennzeichnet,** daß zwischen den Verfahrensschritten t) und u) die Flanken der Gate-Elektroden (G) der MOS-Transistoren, des Kollektorkontaktbereiches (K) und des Emitterkontaktbereiches (E), sowie die Flanken der mit der dritten Isolatorschicht (10) bedeckten p⁺-leitenden Schichtstruktur (7) (Basiskontakt) mit einer zusätzlich erzeugten SiO₂-Schicht (18) versehen werden.

4. Verfahren nach einem der Ansprüche 1 bis 3, **dadurch gekennzeichnet,** daß vor der Metallisierung nach Verfahrensschritt y) die Kontakte aller aktiven Gebiete der Transistoren (T_{A}, T_{B}, T_{C}) mit Ausnahme des Basiskontaktbereiches (B) des Bipolar-Transistors (T_{A}) durch selektive Abcheidung von Metallsilizid (19) oder eines Silizid bildenden Metalles versehen werden.

5. Verfahren nach einem der Ansprüche 1 bis 4, **dadurch gekennzeichnet,** daß im Anschluß an Verfahrensschritt c) in den späteren Feldoxidbereichen (6) eine Siliziumtiefätzung zur Erzielung einer planaren Oberfläche durchgeführt wird.

6. Verfahren nach einem der Ansprüche 1 bis 4, **dadurch gekennzeichnet,** daß anstelle der Verfahrensschritte c) und d) zur Trennung der aktiven Transistorbereiche Gräben in das Substrat (1) geätzt werden, welche mit dielektrischem Material aufgefüllt werden.

7. Verfahren nach einem der Ansprüche 1 bis 6, **dadurch gekennzeichnet,** daß vor dem Verfahrensschritt d) durch Bor-Ionenimplantation unter den Feldoxidbereichen (6) channel stopper-Bereiche (21) erzeugt werden.

## Claims

1. Process for simultaneously producing bipolar (T_{A}) and complementary MOS (CMOS) transistors (T_{B}, T_{C}) on a common silicon substrate (1), in which process there are created on the p-doped silicon substrate (1) n-doped regions (5) which partly serve to receive p-channel transistors (T_{C}) and which are partly situated in the region of insulated n-p-n bipolar transistors (TA), the last named n-doped regions (5) forming the collector of the bipolar transistors (TA), and in which process all the n-doped regions (5) cover buried n⁺-doped zones (2) which are connected by deep-reaching collector connections (4) in the region of the bipolar transistors (T_{A}), characterised by the completion of the following process steps:
a) production of the buried n⁺-doped zones (2) in the p-doped substrate (1) by implantation of n-doping ions after prior masking of the other regions,
b) application of a p- or n-doped epitaxial layer over the entire surface,
c) application of a double layer comprising silicon oxide and silicon nitride and suitable patterning of the silicon nitride layer for the subsequent local oxidation (LOCOS),
d) production of the field oxide (6) needed to isolate the active regions of the transistors (T_{A}, T_{B}, T_{C}) in the substrate (1) by local oxidation using the silicon nitride pattern as oxide mask,
e) creation of the n-doped regions (5) and of p-regions (3) in the substrate (1), extended by the epitaxial layer, by implantation of n- or p-doping ions, respectively, and of the regions for the deep-reaching collector connection (4) by a deep implantation using n-doping ions and drive-in,
f) removal of the nitride/oxide mask,
g) creation of a first insulator layer (11) over the entire surface in a layer thickness which is sufficient as etch stop for the later patterning of a base contact structure,
h) performance of a photoresist procedure and freeing of the bipolar transistor regions (T_{A}), comprising at least base and emitter region, from the first insulator layer (11) by etching,
i) deposition of a p⁺-type layer (7) composed of polysilicon or metal silicide over the entire surface after removal of the photoresist mask,
j) deposition of a second insulator layer (8) over the entire surface,
k) performance of a photoresist procedure and patterning of the p⁺-type layer (7) and of the second insulator layer (8) with vertical edges until the substrate (1) is exposed by means of a dry-edging process in order to define the base region of the bipolar transistors (T_{A}),
l) production of the active base region (9) by boron ion implantation after performing photoresist masking of the other regions,
m) deposition of a third insulator layer (10) over the entire surface with good edge coverage of the structures of the p⁺-type layer (7) and of the second insulator layer (8) after removal of the photoresist mask,
n) performance of an anisotropic etching process to create lateral insulation strips (10) from the third insulator layer at the edges of the p⁺-type layer structures (7) and to free the substrate surfaces in the active regions of the MOS transistors (T_{B}, T_{C}) and in the collector contact region (K) of the bipolar transistors (T_{A}) by etching,
o) application of the gate insulator layer (13) of the MOS transistors (T_{B}, T_{C}),
p) deposition of a first polysilicon layer (14) over the entire surface with a layer thickness of less than 150 nm and doping of said layer (14) with phosphorus,
q) performance of a photoresist procedure and patterning of the first polysilicon layer (14) and of the gate insulator layer (13) situated underneath in such a way that the silicon substrate surface (1) is exposed in the emitter and collector contact regions (E, K), and stripping of the photoresist mask,
r) deposition of a second polysilicon layer (15) over the entire surface with a layer thickness in the range from 100 to 300 nm,
s) performance of a photoresist procedure and patterning of the first and second polysilicon layer (14, 15) to create the gate electrodes (G) of the MOS transistors (T_{B}, T_{C}), and of the collector and emitter contact regions (K, E) of the bipolar transistors (T_{A}),
t) performance of a phosphorus ion implantation to create the source/drain connection regions of the n-channel MOS transistors (T_{B}) and stripping of the resist mask used for patterning in accordance with process step s),
u) performance of an arsenic ion implantation masked with photoresist to create the source/drain zones (16) of the n-channel transistors (T_{B}) and to dope the emitter and collector contact regions (E, K) of the bipolar transistors (T_{A}),
v) performance of a boron ion implantation masked with photoresist to create the source/drain zones (17) of the p-channel transistors (T_{C}),
w) creation of an interlayer (20) over the entire surface, which interlayer (20) serves as insulation oxide, on the surface of the structure,
x) performance of a high-temperature treatment in the region of 900°C to drive arsenic into the source/drain zones (16) and into the emitter and collector regions and also boron into the source/drain zones (17) and into the base contact regions (B),
y) opening of the contact vias to the p⁺- or n⁺-type connections of the active transistor regions and performance of the metallisation.

2. Process according to Claim 1, characterised in that the process step 1) is performed without photoresist masking.

3. Process according to Claim 1 or 2, characterised in that, between the process steps t) and u), the edges of the gate electrodes (G) of the MOS transistors, of the collector contact region (K) and of the emitter contact region (E), and the edges of the p⁺-type layer structure (7) (base contact) covered by the third insulator layer (10) are provided with an additionally created SiO₂ layer (18).

4. Process according to one of Claims 1 to 3, characterised in that, prior to the metallisation in accordance with process step y), the contacts of all active regions of the transistors (T_{A}, T_{B}, T_{C}) with the exception of the base contact region (B) of the bipolar transistor (T_{A}) are provided by selective deposition of metal silicide (19) or of a silicide-forming metal.

5. Process according to one of Claims 1 to 4, characterised in that, following process step c), a silicon deep etching is performed in the subsequent field oxide regions (6) in order to achieve a planar surface.

6. Process according to one of Claims 1 to 4, characterised in that, instead of the process steps c) and d), trenches which are filled with dielectric material are etched in the substrate (1) to isolate the active transistor regions.

7. Process according to one of Claims 1 to 6, characterised in that, prior to process step d), channel-stopper regions (21) are created underneath the field oxide regions (6) by boron ion implantation.

## Revendications

1. Procédé de fabrication simultanée de transistors bipolaires (T_{A}) et de transistors MOS complémentaire (CMOS) (T_{B}, T_{C}) sur un substrat en silicium (1) commun, selon lequel on forme, sur le substrat en silicium (1) dopé du type p, des régions (5) dopées du type n, qui, d'une part, servent à recevoir des transistors (T_{C}) à canal p et qui, d'autre part, sont situées dans la région des transistors bipolaires npn isolés (T_{A}), les régions (5) dopées du type n, indiquées en dernier lieu, formant le collecteur des transistors bipolaires (T_{A}), et selon lequel toutes les régions (5) dopées du type n recouvrent des zones (2) dopées du type n⁺ ensevelies, qui, dans la région des transistors bipolaires (T_{A}), sont raccordées par des bornes de collecteur (4) s'étendant profondément, caractérisé par l'exécution des étapes opératoires suivantes :
a) réalisation des zones ensevelies (2) dopées du type n⁺ dans le substrat (1) dopé du type p, par implantation d'ions réalisant un dopage de type n, après masquage préalable des autres régions,
b) dépôt, sur toute la surface, d'une couche épitaxiale dopée de type p ou n,
c) dépôt d'une couche double composée d'oxyde de silicium et de nitrure de silicium et structuration correspondante de la couche de nitrure de silicium pour la post-oxydation locale (LOCOS),
d) réalisation de l'oxyde de champ (6) nécessaire pour séparer les régions actives des transistors (T_{A},T_{B},T_{C}) dans le substrat (1), par oxydation locale et avec utilisation de la structure en nitrure de silicium comme masque d'oxydation,
e) production des régions (5) dopées du type n et de régions (3) de type p dans le substrat (1), auquel est ajoutée la couche épitaxiale, par implantation d'ions réalisant un dopage du type n et du type p, ainsi que des régions pour la borne profonde de collecteur (4) s'étendant profondément, au moyen d'une implantation avec des ions réalisant un dopage de type n et au moyen d'une diffusion en profondeur,
f) élimination du masque de nitrure/oxyde,
g) production, sur toute la surface, d'une première couche isolante (11) d'une épaisseur suffisante pour que cette couche agisse en tant que dispositif d'arrêt contre la corrosion lors de la structuration ultérieure d'une structure de couche de contact de base,
h) exécution d'une technique utilisant une photolaque et dégagement par corrosion, à partir de la première couche isolante (11), des régions (T_{A}) des transistors bipolaires, qui sont constituées d'au moins une région de base et une région d'émetteur,
i) dépôt, sur toute la surface, d'une couche (7) conductrice du type p⁺ en silicium ou en un siliciure métallique après élimination du masque de photolaque,
j) dépôt, sur toute la surface, d'une deuxième couche isolante (8),
k) exécution d'une technique utilisant une photolaque et structuration de la couche (7) conductrice de type p⁺ et de la deuxième couche isolante (8) comportant des flancs verticaux, jusqu'au dégagement du substrat (1) au moyen d'un procédé de corrosion à sec de manière à définir la région de base des transistors bipolaires (T_{A}),
l) réalisation de la région de base active (9) par implantation d'ions de bore après masquage des autres régions avec la photolaque,
m) dépôt, sur toute la surface, d'une troisième couche isolante (10) qui recouvre bien les bords des structures de la couche (7) conductrice du type p⁺ et de la seconde couche isolante (8), après élimination du masque de photolaque,
n) exécution d'un procédé de corrosion anisotrope pour former des barrettes isolantes latérales (10) à partir de la troisième couche isolante, au niveau des flancs des structures (7) de la couche conductrice de type p+ et pour dégager par corrosion les surfaces du substrat dans les régions actives des transistors MOS (T_{B}, T_{C}) et dans la région du contact de collecteur (K) des transistors bipolaires (T_{A}),
o) dépôt de la couche isolante de grille (13) des transistors MOS (T_{B}, T_{C}),
p) dépôt, sur toute la surface, d'une première couche de polysilicium (14) possédant une épaisseur inférieure à 150 nm et dopage de cette couche (14) avec du phosphore,
q) exécution d'une technique utilisant une photolaque et structuration de la première couche de polysilicium (14) et de la couche sous-jacente d'isolation de grille (13) de manière à dégager la surface (1) du substrat en silicium dans les régions de contact d'émetteur et de collecteur (E,K), et élimination du masque de photolaque par dissolution,
r) dépôt, sur toute la surface, d'une deuxième couche de polysilicium (15) possédant une épaisseur qui se situe entre 100 et 300 nm,
s) exécution d'une technique utilisant une photolaque et structuration des première et seconde couches de polysilicium (14,15) pour produire les électrodes de grille (G) des transistors MOS (T_{B},T_{C}) et la région de contact de collecteur et d'émetteur (K,E) des transistors bipolaires (T_{A}),
t) exécution d'une implantation d'ions de phosphore pour produire les régions des bornes source/drain des transistors MOS à canal n (T_{B}) et élimination par dissolution du masque de laque utilisé pour la structuration conformément à l'étape opératoire (s),
u) exécution d'une implantation d'ions arsenic avec masquage au moyen d'une photolaque, pour la production des zones source/drain (16) des transistors à canal n (T_{B}) et pour le dopage des régions de contact d'émetteur et de collecteur (E,K) des transistors bipolaires (T_{A}),
v) exécution d'une implantation d'ions de bore avec masquage au moyen d'une photolaque pour la production des zones source/drain (17) des transistors à canal P (T_{C}),
w) production, sur toute la surface, d'une couche intermédiaire (20) utilisée en tant qu'oxyde isolant, sur la surface de la structure,
x) exécution d'un traitement à haute température au voisinage de 900°C pour la diffusion en profondeur de l'arsenic dans les zones source/drain (16) et dans les zones d'émetteur et de collecteur ainsi que pour la diffusion en profondeur du bore dans les zones source/drain (17) et dans les régions de contact de base (B),
y) ouverture des trous de contact aboutissant aux bornes conductrices du type p⁺ et n⁺ des régions actives des transistors et exécution de la métallisation.

2. Procédé suivant la revendication 1, caractérisé par le fait que l'étape opératoire 1) est exécutée sans masquage par une photolaque.

3. Procédé suivant la revendication 1 ou 2, caractérisé par le fait qu'entre les étapes opératoires t) et u), les flancs des électrodes de grille (g) des transistors MOS de la région du contact de collecteur (K) et de la région du contact d'émetteur (E), ainsi que les flancs de la structure de couches (7) conductrice de type p⁺ (contact de base) recouverte par la troisième couche isolante (10), sont pourvues d'une couche de SiO₂ formée en supplément.

4. Procédé suivant l'une des revendications 1 à 3, caractérisé par le fait qu'avant la métallisation conformément à l'étape opératoire y), les contacts de toutes les régions actives des transistors (T_{A},T_{B},T_{C}), à l'exception de la région de contact de base (B) du transistor bipolaire (T_{A}), sont munis par dépôt sélectif, de siliciure métallique (19) ou d'un métal formant un siliciure.

5. Procédé suivant l'une des revendications 1 à 4, caractérisé par le fait qu'à la suite de l'étape opératoire c), on exécute une corrosion profonde du silicium pour obtenir une surface planar, dans les régions d'oxyde de champ (6) formées ultérieurement.

6. Procédé suivant l'une des revendications 1 à 4, caractérisé par le fait qu'à la place des étapes opératoires c) et d) pour la séparation des régions actives du transistor, on ménage par corrosion, dans le substrat (1), des sillons qui sont remplis d'un matériau diélectrique.

7. Procédé suivant l'une des revendications 1 à 6, caractérisé par le fait qu'avant l'étape opératoire d), on forme, par implantation d'ions de bore, des régions d'arrêt de canal (21) (channel stop), en-dessous des régions d'oxyde de champ (6).
